# FASCICULE DE BREVET EUROPEEN

(11) **EP 1 328 969 B1**
(45) Date de publication et mention de la délivrance du brevet: **07.12.2011**
(21) Numéro de dépôt: 01976365.5
(22) Date de dépôt: 05.10.2001
(51) Int. Cl.: H01L 21/28, H01L 21/336

(54) **PROCÉDÉ DE FORMATION D'UN TRANSISTOR MOS**
HERSTELLUNGSVERFAHREN EINES MOS-TRANSISTORS
METHOD OF MANUFACTURING A MOS TRANSISTOR

(30) Priorité: 06.10.2000 FR 0012806
(43) Date de publication de la demande: 23.07.2003
(73) Titulaire: STMicroelectronics S.A., 92120 Montrouge (FR)
(72) Inventeur: GUYADER, François, 38330 Montbonnot Saint-Martin (FR); ARNAUD, Franck, F- 38700 Le Sappey en Chartreuse (FR)
(74) Mandataire: de Beaumont, Michel
(86) Numéro de dépôt international: PCT/FR2001/003076
(87) Numéro de publication internationale: WO 2002/029881

(56) Documents cités:
- US-A- 5 015 598
- US-A- 5 397 909
- US-A- 6 121 100
- US-A- 6 121 137
- PATENT ABSTRACTS OF JAPAN vol. 1999, no. 02, 26 février 1999 (1999-02-26) -& JP 10 303297 A (MITSUBISHI ELECTRIC CORP), 13 novembre 1998 (1998-11-13)
- PATENT ABSTRACTS OF JAPAN vol. 016, no. 465 (E-1270), 28 septembre 1992 (1992-09-28) -& JP 04 165629 A (NEC CORP), 11 juin 1992 (1992-06-11)
- PATENT ABSTRACTS OF JAPAN vol. 012, no. 162 (E-609), 17 mai 1988 (1988-05-17) -& JP 62 274665 A (NEC CORP), 28 novembre 1987 (1987-11-28)
- PATENT ABSTRACTS OF JAPAN vol. 2000, no. 03, 30 mars 2000 (2000-03-30) -& JP 11 345963 A (NEC CORP), 14 décembre 1999 (1999-12-14)
- PATENT ABSTRACTS OF JAPAN vol. 017, no. 463 (E-1420), 24 août 1993 (1993-08-24) -& JP 05 109760 A (SEIKO EPSON CORP), 30 avril 1993 (1993-04-30)
- KUIPER A. E. T. ET AL: "Thermal oxidation of silicon nitride and silicon oxynitride films", JOURNAL OF VACUUM SCIENCE AND TECHNOLOGY B, vol. 7, no. 3, May 1989 (1989-05), pages 455-465,
- HABRAKEN F. H. P. M. ET AL: "Silicon nitride and oxynitride films", MATERIALS SCIENCE & ENGINEERING R: REPORTS JULY 1994 SWITZERLAND, vol. R12, July 1994 (1994-07), pages 123-175,

## Description

La présente invention concerne, de façon générale, la fabrication de transistors de type MOS de longueur de grille inférieure au micromètre. Plus particulièrement, la présente invention concerne la formation des régions de source et de drain dans un substrat semiconducteur.

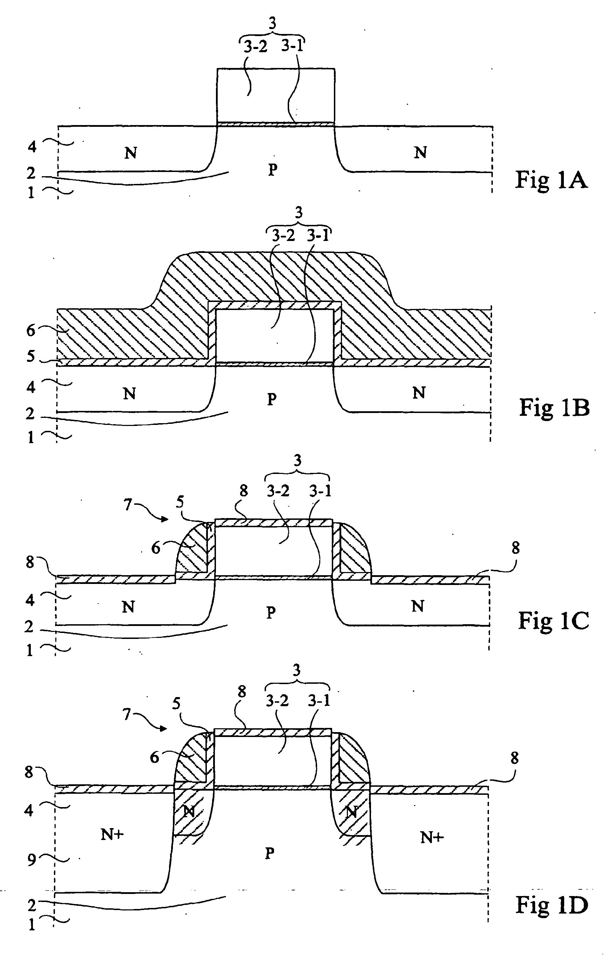

Les figures 1A à 1D illustrent en vue en coupe schématique et partielle un transistor MOS à différentes étapes d'un procédé de fabrication classique.

Comme l'illustre la figure 1A, on commence par définir, dans un substrat semiconducteur 1 d'un premier type de conductivité, une région de canal 2 par une grille isolée 3. La grille 3 est obtenue par le dépôt et la gravure successives d'une couche mince isolante 3-1 et d'une couche 3-2 d'un matériau conducteur. On soumet ensuite l'ensemble de la structure à une implantation à faible énergie et à faible dose de dopants du type de conductivité opposé à celui du substrat 1. On forme ainsi dans le substrat 1, de part et d'autre du canal 2, des régions 4 faiblement dopées (implantation LDD).

On notera que de tels transistors dont le canal 2 est délimité par des régions faiblement dopées (LDD) 4 sont dits "transistors de type LDD". On considérera en outre dans la présente description de tels transistors "miniaturisés", c'est-à-dire dont la grille présente une longueur de grille inférieure au micromètre.

Par souci de simplification, on considérera ci-après, à titre d'exemple non-limitatif, que le substrat 1 est en silicium monocristallin de type P. On implantera alors, dans les régions 4, des dopants de type N, tels que du phosphore ou, de préférence, de l'arsenic. L'isolant de grille 3-1 est généralement de l'oxyde de silicium (SiO₂) et le conducteur de grille 3-2 du silicium polycristallin.

L'implantation LDD est suivie d'un recuit. Ce recuit est destiné à permettre une recristallisation de la surface du substrat 1. En effet, lors de l'impact des atomes dopants et lors de leur pénétration, le réseau cristallin du substrat 1 est déformé. Ce recuit est effectué à une température suffisamment faible et pendant un temps suffisamment court pour ne pas provoquer la diffusion des dopants. On effectue généralement un recuit à une température comprise entre 900 et 1050°C, pendant sensiblement 20 secondes.

Aux étapes suivantes, illustrées en figure 1B, on dépose successivement sur l'ensemble de la structure une couche mince d'oxyde de silicium 5, et une couche 6 de nitrure de silicium (Si₃N₄).

Aux étapes suivantes, illustrées en figure 1C, on grave successivement les couches 6 et 5 de façon à ne laisser subsister des portions de celles-ci qu'autour de la grille 3. On forme ainsi un espaceur latéral composite 7 autour de la grille isolée 3.

Ensuite, on provoque la croissance d'une couche sacrificielle 8 d'oxyde de silicium, d'une épaisseur de 3 à 10 nm. La couche 8 est formée sur les surfaces apparentes de silicium, c'est-à-dire, sur le substrat 1, à la surface des régions 4, ainsi qu'à la surface du silicium polycristallin de grille 3-2.

On implante ensuite à travers la couche 8 un dopant du deuxième type de conductivité à haute énergie et à forte dose. On forme ainsi, comme l'illustre la figure 1D, de part et d'autre du canal 2, des régions 9 de source et de drain fortement dopées, par exemple de type N+.

On effectue ensuite un nouveau recuit dit d'activation à une température de l'ordre de 1000°C, pendant un temps relativement court, par exemple environ quinze secondes. Ce recuit a pour objet d'activer les dopants implantés et de recristalliser la structure cristalline déformée par l'implantation des régions 9.

Les inconvénients de ce procédé classique résident dans les dégâts successifs apportés à la structure cristalline au voisinage du canal 2 défini par la grille isolée 3.

En effet, le premier recuit de recristallisation ne permet pas une restauration complète de la structure cristalline initiale. Il demeure, notamment en surface, et le long de la limite de diffusion des dopants une zone particulièrement fragilisée ou zone d'amorphisation. Cette zone est d'autant plus importante et d'autant plus endommagée que l'ion implanté est lourd. Ainsi, dans le cas d'un transistor à canal P, l'implantation étant effectuée à l'aide d'atomes de bore relativement peu massifs, un tel recuit suffit pour supprimer la plupart des défauts isolés créés. Par contre, dans le cas de l'implantation d'atomes lourds, par exemple d'arsenic lors de la formation d'un transistor MOS à canal N, il demeure après le recuit des défauts ou failles dans le réseau cristallin.

Ensuite, lors du dépôt de la couche 6, compte tenu des contraintes relativement importantes imposées par le nitrure de silicium, le substrat 1 sous-jacent (canal 2 sous-jacent à la grille 3 et régions LDD 4), est déformé sous l'effet d'une contrainte mécanique.

Après formation des espaceurs 7, le réseau conserve une certaine déformation et une certaine fragilité. Cet effet est particulièrement important dans les régions sous-jacentes à l'espaceur latéral 7, on trouve alors sous les espaceurs une zone soumise à contrainte et en dehors de la limite des espaceurs une zone comportant des défauts.

Lors de l'implantation ultérieure des régions de source et de drain 9, de nouveau, le réseau est déformé. Les défauts structurels ainsi formés sont d'autant plus grands et nombreux que les atomes implantés sont lourds et qu'on se trouve dans une région particulièrement sensible telle que les zones proches de l'espaceur latéral. Il se crée des boucles de dislocation.

Le recuit d'activation est relativement efficace dans le cas de l'implantation d'atomes relativement légers, comme dans le cas d'atomes de bore lors de la réalisation, dans un substrat de type N, d'un transistor MOS à canal P. Toutefois, dans le cas d'implantation d'atomes relativement lourds, 1 tels que des atomes d'arsenic dans le cas de la formation de transistors MOS à canal N, ce recuit s'avère insuffisant.

La zone située dans le silicium sous la frontière extérieure des espaceurs se trouve correspondre à la limite entre une zone soumise à contrainte et une zone comportant des défauts et est donc particulièrement perturbée. Ceci provoque des dysfonctionnements tels qu'une modification des seuils de commutation des transistors et l'apparition de courants de fuite alors que le transistor est commandé pour ne pas être conducteur. Ces dysfonctionnements sont d'autant plus importants que les dimensions du transistor sont réduites.

Le document US 5015598 divulgue un procédé de formation d'un transistor MOS avec une étape d'oxydation simultanée du substrat, de la grille et des espaceurs.

La présente invention vise donc à proposer un nouveau procédé de fabrication fournissant des transistors MOS présentant un seuil de commutation stabilisé et à courant de fuite réduit.

Pour atteindre cet objet, la présente invention prévoit un procédé de formation selon la revendication 1.

La présente invention permet d'obtenir un transistor MOS comportant, dans un substrat d'un premier type de conductivité, un canal défini par une grille isolée munie d'espaceurs latéraux en nitrure de silicium formée sur le substrat, des premières régions faiblement dopées du deuxième type de conductivité séparant le canal de deuxièmes régions fortement dopées du deuxième type de conductivité, les premières et deuxièmes régions étant formées de part et d'autre de la grille, la limite entre les premières et deuxièmes régions se trouvant au-delà de la région sous-jacente aux espaceurs.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A à 1D illustrent, en vue en coupe partielle et schématique, un procédé classique de fabrication d'un transistor MOS ; et
les figures 2A et 2B illustrent, en vue en coupe partielle et schématique, des étapes successives de fabrication d'un transistor MOS selon l'invention.

Par souci de clarté, les mêmes éléments ont été désignés par les mêmes références aux différentes figures et, de plus, comme cela est habituel dans la représentation des circuits intégrés, les diverses figures ne sont pas tracées à l'échelle.

La présente invention se base sur une analyse de l'origine des dysfonctionnements d'un transistor classique. Les inventeurs sont arrivés à la conclusion que les diverses tentatives classiques de restauration de la structure cristalline du substrat ont des effets relativement limités. De telles tentatives; par exemple des recuits de recristallisation ou des modifications des conditions (énergie et/ou dose) des diverses implantations, sont inopérantes dans le cas de transistors miniaturisés de type LDD. Selon les inventeurs, les dysfonctionnements proviennent alors de la formation de la limite entre une région de drain/source 9 et une région LDD 4 dans une zone particulièrement endommagée, hachurée en figure 1D, proche du canal 2.

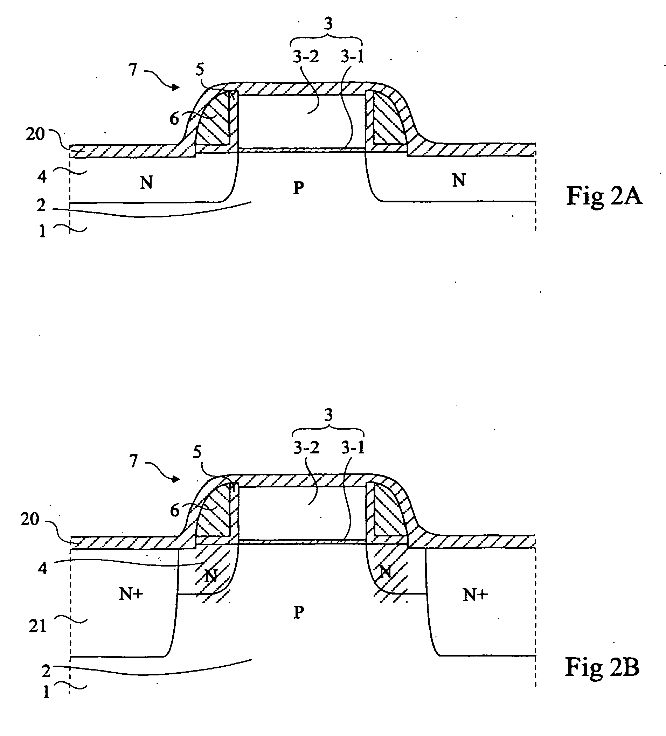

Un procédé de formation de transistor MOS selon la présente invention est exposé ci-après, à titre d'exemple non-limitatif, en relation avec les figures 2A et 2B, dans le cas particulier de la formation d'un transistor MOS à canal N dans un substrat semiconducteur 1 de type P.

Le procédé selon l'invention commence par des étapes similaires à celles décrites précédemment en relation avec les figures 1A et 1C :
- définition d'un canal 2 dans le substrat 1, par formation d'une grille 3 constituée d'un isolant de grille 3-1, par exemple une couche d'oxyde de silicium d'une épaisseur d'environ 2 nm, et d'un conducteur de grille 3-2, par exemple une couche de silicium polycristallin d'une épaisseur d'environ 20 nm ;
- formation de régions LDD 4, par exemple de type N, de préférence par implantation d'arsenic à faible énergie et faible dose ; et
- formation d'espaceurs 7 en nitrure de silicium, par dépôt et gravure d'une couche 6 de nitrure de silicium d'une épaisseur d'environ 50 nm. De préférence, la formation des espaceurs 7 en nitrure de silicium est précédée du dépôt d'une première couche isolante 5, par exemple en oxyde de silicium, relativement mince, d'une épaisseur d'environ 20 nm.

A ce stade de la fabrication, comme l'illustre la figure 2A, on oxyde selon l'invention toutes les surfaces apparentes. En d'autres termes, on forme une couche 20 d'oxyde de silicium tant sur les surfaces en silicium du substrat 1 (régions LDD 4) et de la grille 3 que sur les portions 6 en nitrure de silicium des espaceurs 7. Les conditions de formation de la couche 20 résultant d'une oxydation simultanée du silicium et du nitrure de silicium seront discutées ultérieurement.

A l'étape suivante, illustrée en figure 2B, on forme des régions 21 de drain et de source fortement dopées, par exemple de type N+, par une implantation à forte énergie et à forte dose, par exemple d'arsenic. Les régions 21 sont plus éloignées de la zone sous-jacente à la portion en nitrure de silicium 6 que les régions homologues du transistor classique de la figure 1D.

La structure illustrée en figure 2B pourra être parachevée par les diverses étapes classiques de réalisation de composants semiconducteurs (prises de contact, réalisation de connexions, ...).

On notera que lors de la formation des transistors selon l'invention, on peut également prévoir des recuits de recristallisation après chaque étape d'implantation. Ces recuits seront alors effectués dans des conditions classiques, par exemple, telles qu'exposées en relation avec les figures 1A et 1D.

Un avantage de la présente invention est d'éloigner la limite des régions de source et de drain 21 des régions fortement contraintes situées sous le nitrure de silicium et hachurées en figures 1D et 2B. En outre, la réoxydation du nitrure entraîne que la frontière de la zone soumise à contrainte recule, tandis que la frontière de la zone soumise à défauts n'avance pas. On obtient donc une région de silicium de particulièrement bonne qualité dans la région limite des parties de drain et de source peu dopées et des parties de drain et de source fortement dopées. On notera que ce résultat (création d'une zone sans défaut) n'aurait pas été obtenu par le dépôt d'une couche d'oxyde sur le nitrure: La présente invention permet donc de fabriquer des transistors présentant des seuils de commutation plus réguliers et plus stables et de plus faible courant de fuite.

Un autre avantage de la présente invention réside en ce qu'elle permet de réduire le taux de dispositifs (transistors MOS) présentant des dysfonctionnements. En effet, lors de la gravure de la couche 6 de nitrure de silicium pour former des espaceurs (comme cela a été exposé précédemment en relation avec les figures 1B et 1C), il est fréquent que des résidus, généralement isolés, de nitrure de silicium demeurent en place. Avec les procédés classiques, de tels résidus demeurent généralement en place pendant tout le reste du procédé de fabrication. Leur présence peut affecter le fonctionnement du transistor. Grâce à l'oxydation selon l'invention du nitrure de silicium, de tels résidus sont oxydés ou complètement encapsulés dans la couche isolante sacrificielle 20. Par conséquent, lors de l'étape ultérieure (non-représentée) de retrait de l'oxyde sacrificiel d'implantation 20, ils sont éliminés. Cela contribue encore à stabiliser le fonctionnement des transistors MOS obtenus selon le procédé de l'invention.

A titre d'exemple, l'étape d'oxydation simultanée selon l'invention est effectuée en utilisant un procédé de croissance de couches d'oxyde de silicium ultra-minces, tel qu'une oxydation in situ en présence de vapeur d'eau (In Situ Steam Generated - ISSG - oxidation) ou sous plasma d'oxygène (remote plasma oxidation, ce deuxième exemple ne fait pas partie de l'invention). On s'attachera à utiliser un procédé tel que l'oxydation du nitrure de silicium se produise sensiblement à la même vitesse que celle du silicium. Il est toutefois possible d'utiliser des procédés d'oxydation légèrement sélectifs, pour autant que la couche 20 obtenue réponde aux critères d'épaisseur suivants.

L'épaisseur de la couche 20 est choisie en fonction d'un compromis entre diverses conditions. D'une part, l'épaisseur totale de la couche 20 au-dessus du substrat 1 doit être suffisamment faible pour permettre une pénétration des dopants à une profondeur appropriée dans le substrat 1 sans avoir à modifier les énergies ou les doses d'implantation. D'autre part, la partie de la couche 20 en surépaisseur par rapport à l'épaisseur initiale (avant oxydation) de l'espaceur 7 doit être suffisamment importante pour provoquer un éloignement suffisant des régions 21 par rapport à l'espaceur initial 7.

Par exemple, en utilisant un procédé de type vapeur d'eau (ISSG), on pourra obtenir une couche 20 d'une épaisseur comprise entre 8 et 10 nm. Cette épaisseur est obtenue par une même consommation de l'ordre de 3 nm de l'épaisseur des parties en silicium (substrat 1, grille 3) et des parties en nitrure de silicium, et une croissance d'une couche supplémentaire d'oxyde de silicium sur une épaisseur de l'ordre de 5 à 7 nm. Les transistors ainsi obtenus présentent une densité de courant de fuite comprise entre 1 et 10.10⁻¹² A/µm², alors que des transistors classiques présentaient une telle densité de l'ordre de 100.10⁻¹² A/µm².

un autre avantage de la présente invention est qu'elle permet l'obtention de transistors miniaturisés, notamment du fait que la réoxydation d'une couche de nitrure peut être effectuée avec un très bon contrôle des épaisseurs d'oxyde formées.

Bien entendu, la présente invention est susceptible de diverses variantes et modifications qui apparaîtront à l'homme de l'art. En particulier, la présente invention s'applique à tous types d'espaceurs monocouche ou composites essentiellement constitués de nitrure de silicium.

De plus, les principes selon la présente invention ont été exposés précédemment en relation avec le cas particulier de la réalisation d'un transistor MOS à canal N dans un substrat de type P. L'homme de l'art comprendra que l'on pourrait selon les mêmes principes réaliser un transistor MOS de type P dans un substrat de type N. En outre, bien que la présente invention ait été décrite précédemment dans le cadre de- la réalisation d'un seul type de transistor, elle s'applique également à des procédés complémentaires.

## Revendications

1. Procédé de formation, dans un substrat (1) d'un premier type de conductivité, d'un transistor MOS, comprenant les étapes suivantes :
a) former sur le substrat une grille isolée (3) ;
b) implanter un dopant du deuxième type de conductivité ;
c) former sur les bords de la grille des espaceurs (7) en nitrure de silicium ;
d) oxyder simultanément les surfaces apparentes du substrat, de la grille et des espaceurs ; et
e) procéder à une implantation de drain et de source, dans lequel l'étape d) d'oxydation simultanée est effectuée en présence de vapeur d'eau, d'où il résulte la formation d'une couche d'oxyde de silicium (20) d'une épaisseur comprise entre 3 et 10 nm sur le substrat (1) et sur les espaceurs (7) en nitrure de silicium.

2. Procédé selon la revendication 1, **caractérisé en ce que** l'étape b) d'implantation est suivie d'un recuit de recristallisation.

3. Procédé selon la revendication 1, **caractérisé en ce que** l'étape c) de formation des espaceurs (7) en nitrure de silicium est précédée du dépôt d'une couche d'oxyde de silicium.

## Claims

1. A method for forming, in a substrate (1) of a first conductivity type, a MOS transistor, including the steps of:
a) forming an insulated gate on the substrate (3);
b) implanting a dopant of the second conductivity type;
c) forming silicon nitride spacers (7) on edges of the gate;
d) simultaneously oxidizing the exposed surfaces of the substrate, of the gate, and of the spacers; and
e) performing a drain and source implantation, wherein step d) of simultaneous oxidation is performed in the presence of steam, which results in the forming of a silicon oxide layer (20) having a thickness ranging between 3 and 10 nm on the substrate (1) and on the silicon nitride spacers (7).

2. The method of claim 1, wherein the implantating step b) is followed by a recrystallization anneal.

3. The method of claim 1, wherein step c) of forming of the silicon nitride spacers (7) is preceded by the deposition of a silicon oxide layer.

## Patentansprüche

1. Ein Verfahren zum Bilden, in einem Substrat (1) eines ersten Leitfähigkeitstyps, eines MOS-Transistors, wobei das Verfahren die folgenden Schritte aufweist:
a) Bilden eines isolierten Gatters auf dem Substrat (3);
b) Implantieren einer Dotierung von dem zweiten Leitfähigkeitstyp;
c) Bilden von Siliziumnitritabstandshaltern (7) auf Rändern von dem Gatter;
d) gleichzeitiges Oxidieren der exponierten Oberflächen von dem Substrat von dem Gatter und von den Abstandshaltern; und
e) Durchführen einer Drain- und Source-Implantation, wobei der Schritt d), der gleichzeitigen Oxidierung in der Präsenz von Dampf durchgeführt wird, was zum Bilden von einer Siliziumoxidschicht (20) führt, die eine Dicke im Bereich zwischen 3 und 10 nm besitzt, und zwar auf dem Substrat (1) und auf den Siliziumnitritabstandshaltern (7).

2. Verfahren nach Anspruch 1, wobei der Implantationsschritt b) gefolgt wird von einem Wiederkristallisierungsglühen bzw. recrystallization anneal.

3. Verfahren nach Anspruch 1, wobei dem Schritt c) des Bildens der Siliziumnitritabstandshalter (7) die Abscheidung von einer Siliziumoxidschicht vorausgeht.
